# EUROPEAN PATENT APPLICATION

(11) **EP 2 461 366 A1**
(43) Date of publication of application: **06.06.2012**
(21) Application number: 10804216.9
(22) Date of filing: 28.06.2010
(51) Int. Cl.: H01L 31/04

(54) **PASTE COMPOSITION AND SOLAR CELL ELEMENT USING SAME**

(30) Priority: 30.07.2009 JP 2009177413
(71) Applicant: Toyo Aluminium Kabushiki Kaisha, Osaka-shi, Osaka 541-0056 (JP)
(72) Inventor: ISHIBASHI, Naoaki, Osaka-shi Osaka 541-0056 (JP); KIKUCHI, Ken, Osaka-shi Osaka 541-0056 (JP); OCHI, Yutaka, Osaka-shi Osaka 541-0056 (JP)
(74) Representative: Grünecker, Kinkeldey, Stockmair & Schwanhäusser
(86) International application number: PCT/JP2010/060944
(87) International publication number: WO 2011/013469

(57) **Abstract**

Provided are a paste composition capable of not only meeting appearance characteristics in that no bow of a silicon semiconductor substrate is caused and no blisters and globules of aluminum in the aluminum electrode layer obtained after firing are caused, but also meeting characteristics in that adhesiveness of an aluminum electrode layer and the silicon semiconductor substrate is enhanced and in that reaction of the aluminum electrode layer and moisture is suppressed; and a solar cell element including electrodes formed by using the composition. The paste composition is a paste used for forming an electrode (8) on a silicon semiconductor substrate (1), comprising: an aluminum powder, an organic vehicle, and glass frit, the glass frit including at least one kind of a transition metal oxide selected from the group consisting of a titanium oxide, a vanadium oxide, an iron oxide, a molybdenum oxide, a neodymium oxide, and a tungsten oxide. A solar cell element includes a back side electrode formed by using the above paste composition.

## Description

### TECHNICAL FIELD

The present invention relates generally to paste compositions and solar cell elements using the same. More particularly, the present invention relates to a paste composition including an aluminum powder, which is used for forming an electrode on a silicon semiconductor substrate constituting a crystalline silicon solar cell, and to a solar cell element formed using the same.

### BACKGROUND ART

As electronic components each having an electrode formed on a silicon semiconductor substrate, solar cell elements disclosed in Japanese Patent Application Laid-Open Publication No. 2000-90734 (hereinafter, referred to as Patent Literature 1) and Japanese Patent Application Laid-Open Publication No. 2004-134775 (hereinafter, referred to as Patent Literature 2) have been known.

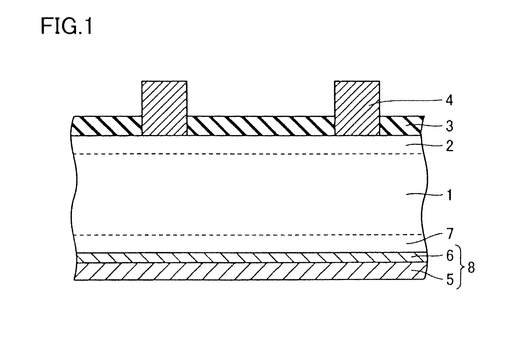

Fig. 1 is a schematic view showing a general sectional structure of a solar cell element.

As shown in Fig. 1, the solar cell element is structured by using a p-type silicon semiconductor substrate 1 whose thickness is 180 through 250 µm. On a light receiving surface of the p-type silicon semiconductor substrate 1, an n-type impurity layer 2 whose thickness is 0.3 through 0.6 µm, and an antireflection film 3 and grid electrodes 4, which are on the n-type impurity layer 2, are formed.

On a back surface of the p-type silicon semiconductor substrate 1, an aluminum electrode layer 5 is formed. The formation of the aluminum electrode layer 5 is conducted through applying an aluminum paste composition containing an aluminum powder, a glass frit, and an organic vehicle by employing screen printing or the like; conducting drying; and thereafter, firing the aluminum paste composition at a temperature greater than or equal to 660°C (a melting point of aluminum) for a short period of time. During the firing, the aluminum is diffused inside of the p-type silicon semiconductor substrate 1, whereby an Al-Si alloy layer 6 is formed of the aluminum electrode layer 5 and the p-type silicon semiconductor substrate 1 and concurrently, a p⁺ layer 7 is formed as an impurity layer resulting from diffusion of aluminum atoms. The presence of the p⁺ layer 7 prevents recombination of electrons, and therefore, a BSF (Back Surface Field) effect which enhances an efficiency of collecting generated carriers can be obtained.

As described above, when the aluminum paste composition is fired to form the aluminum electrode layer 5, appearance characteristics, for example, in that no bow of the p-type silicon semiconductor substrate 1 is caused and no blisters and globules of aluminum in the aluminum electrode layer 5 are caused, of the p-type semiconductor substrate 1 and the aluminum electrode layer 5 are required. In other words, an aluminum paste composition capable of meeting the above-mentioned appearance characteristics has been demanded.

On the other hand, a solar cell module is configured by arranging a multitude of solar cell elements. This solar cell module is installed outdoors and used. In recent years, it has been required that upon and after manufacturing the solar cell module, the aluminum electrode layer 5 is not exfoliated. In addition, after the manufactured solar cell module has been installed outdoors, it has been required that the aluminum electrode layer 5 is not exfoliated from the p-type silicon semiconductor substrate 1.

In order to meet the above-mentioned required characteristics, it has been required that adhesiveness of the aluminum electrode layer 5 and the p-type silicon semiconductor substrate 1, obtained after the firing, is further enhanced.

Japanese Patent Application Laid-Open Publication No. 2008-166344 (hereinafter, referred to as Patent Literature 3) discloses an electrically conductive paste capable of forming a back side electrode having a high adhesion strength, in which an Al-Mg alloy powder or a compound whose chief ingredient is Mg included in an aluminum powder is added.

Japanese Patent Application Laid-Open Publication No. 2008-159912 (hereinafter, referred to as Patent Literature 4) discloses an electrically conductive paste capable of forming a back side electrode having a high adhesion strength, in which a composite Al powder formed by fixing, on a surface of a fine Al powder, a finer glass powder having a low melting point is used.

Japanese Patent Application Laid-Open Publication No. 2000-90733 (hereinafter, referred to as Patent Literature 5) discloses an electrically conductive paste, capable of evenly forming an Al-Si eutectic structure layer without clearance in an interface between a back side electrode and a p-type Si semiconductor substrate and capable of enhancing a conversion efficiency of a solar cell, which includes an Al powder, glass frit, and a vehicle, the glass frit containing: 30 through 70 mol% of Bi₂O₃; 20 through 60 mol% of B₂O₃; and 10 through 50 mol% of SiO₂.

As glass frit included in an aluminum paste for forming a back side electrode of a solar cell, glass frit which includes, as a chief ingredient, an oxide such as a PbO-B₂O₃-SiO₂ based oxide, a PbO-B₂O₃-Al₂O₃ based oxide, a PbO-B₂O₃-ZnO based oxide, a Bi₂O₃-B₂O₃-SiO₂ based oxide, and a Bi₂O₃-B₂O₃-ZnO based oxide has been known. The conventional glass frit including PbO and B₂O₃ as chief ingredients has action to promote reaction of an aluminum powder in an aluminum paste and silicon of a substrate during firing of the aluminum paste.

As mentioned above, PbO is an important ingredient in the glass frit included in the paste for forming the electrode of the solar cell. However, because of the concerns for the environmental issues, the use of PbO and similarly, the use of CdO have been limited as far as possible. Therefore, for example, Japanese Unexamined Patent Application Publication No. 2008-543080 (hereinafter, referred to as Patent Literature 6) proposes a paste composition including no harmful substances such as Pb and Cd.

There may be a case where the conventional glass frit including PbO and B₂O₃ as chief ingredients abruptly advances reaction of aluminum and silicon and increases a produced amount of an Al-Si alloy, and blisters and globules of aluminum are easily caused in an aluminum electrode layer. Also to solve the above-mentioned problem, a paste composition not including PbO as far as possible has been required.

### CITATION LIST

### PATENT LITERATURE

Patent Literature 1: Japanese Patent Application Laid-Open Publication No. 2000-90734
Patent Literature 2: Japanese Patent Application Laid-Open Publication No. 2004-134775
Patent Literature 3: Japanese Patent Application Laid-Open Publication No. 2008-166344
Patent Literature 4: Japanese Patent Application Laid-Open Publication No. 2008-159912
Patent Literature 5: Japanese Patent Application Laid-Open Publication No. 2000-90733
Patent Literature 6: Japanese Unexamined Patent Application Publication No. 2008-543080

### SUMMARY OF THE INVENTION

### TECHNICAL PROBLEM

In recent years, it has been required that not only no exfoliation of an aluminum electrode layer 5 occur upon and after manufacturing a solar cell module and no exfoliation of the aluminum electrode layer 5 from a p-type silicon semiconductor substrate 1 occur after installing the manufactured solar cell module outdoors, but also moisture penetrating into an inside of the solar cell module should not react to the aluminum electrode layer 5. Furthermore, it has been required that hydrogen gas generated by the reaction of the aluminum electrode layer 5 and the moisture should not cause air bubbles inside the solar cell module and should not yellow a back surface protective sheet.

In order to meet these required characteristics, it has been required that not only adhesiveness of the p-type silicon semiconductor substrate 1 and the aluminum electrode layer 5 obtained after the firing be further enhanced, but also the reaction of the aluminum electrode layer 5 and the moisture be suppressed. In other words, an aluminum paste composition capable of meeting all of the above-mentioned characteristics has been demanded.

However, with respect to the electrically conductive pastes disclosed in Patent Literature 3, Patent Literature 4, and Patent Literature 5, the characteristic in that the reaction of the moisture and the aluminum electrode layer obtained after the firing is suppressed has not been examined at all. In addition, although Patent Literature 6 discloses the paste composition including no harmful substances such as Pb and Cd, the characteristic in that the reaction of the moisture and the aluminum electrode layer obtained after the firing is suppressed has not been examined therein at all.

In addition, Patent Literatures 3 through 6 do not disclose that depending on composition of glass frit included in a paste composition, the adhesiveness of the aluminum electrode layer and the silicon semiconductor substrate is further enhanced and that the reaction of the aluminum electrode layer and the moisture is suppressed.

Therefore, objects of the present invention are to solve the above-mentioned problems and to provide a paste composition capable of not only meeting the appearance characteristics in that no bow of the silicon semiconductor substrate is caused and no blisters and globules of aluminum in the aluminum electrode layer obtained after firing are caused, but also meeting the characteristics in that the adhesiveness of the aluminum electrode layer and the silicon semiconductor substrate is enhanced and in that the reaction of the aluminum electrode layer and the moisture is suppressed; and a solar cell element including electrodes formed by using the composition.

### SOLUTION TO PROBLEM

In order to solve the problems of the conventional technology, the present inventors have devoted themselves to studies. As a result, the present inventors found that the above-mentioned objects can be achieved by including, in a paste, glass frit having specific composition, that is, glass frit including a limited kind of a transition metal oxide. Based on the findings, the paste composition according to the present invention has the following features.

The paste composition according to the present invention is a paste composition used for forming an electrode on a silicon semiconductor substrate, comprising: an aluminum powder, an organic vehicle, and glass frit, the glass frit including at least one kind of a transition metal oxide selected from the group consisting of a titanium oxide, a vanadium oxide, an iron oxide, a molybdenum oxide, a neodymium oxide, and a tungsten oxide.

In the paste composition according to the present invention, it is preferable that the glass frit includes no lead or includes 0.1% by mass or less of lead.

In addition, in the paste composition according to the present invention, it is preferable that the glass frit further includes at least one kind selected from the group consisting of a boron oxide, a bismuth oxide, a silicon oxide, an aluminum oxide, a tin oxide, a phosphorus oxide, a manganese oxide, a barium oxide, an antimony oxide, a lithium oxide, a sodium oxide, and a potassium oxide.

Furthermore, in the paste composition according to the present invention, it is preferable that 10% by mass or more and 95% by mass or less of the above-mentioned transition metal oxide is included in the glass frit.

In the paste composition according to the present invention, it is preferable that 0.03% by mass or more and 10% by mass or less of the glass frit is included therein.

A solar cell element according to the present invention includes an electrode formed by applying the paste composition having any of the above-described features onto a silicon semiconductor substrate and thereafter, firing a resultant.

### ADVANTAGEOUS EFFECTS OF THE INVENTION

As described above, according to the present invention, by using a paste composition which includes glass frit including a limited kind of a transition metal oxide, not only appearance characteristics in that no bow of a silicon semiconductor substrate is caused and no blisters and globules of aluminum in the aluminum electrode layer obtained after firing are caused can be met, but also characteristics in that adhesiveness of an aluminum electrode layer and the silicon semiconductor substrate is enhanced and in that reaction of the aluminum electrode layer and moisture is suppressed can be met, thus allowing yields of manufacturing solar cell elements and solar cell modules to be improved.

### BRIEF DESCRIPTION OF THE DRAWINGS

Fig. 1 is a schematic view showing a general sectional structure of a solar cell element as one embodiment, to which the present invention is applicable.

### DESCRIPTION OF EMBODIMENTS

A paste composition according to the present invention includes: an aluminum powder, an organic vehicle, and glass frit including a limited kind of a transition metal oxide.

### <Glass Frit>

It is assumed that glass frit has action to help reaction of aluminum and silicon and sintering of the aluminum powder itself. However, in a case where the glass frit having the conventional composition is used, it has been impossible to obtain a solar cell element having both characteristics in that adhesiveness of an aluminum electrode layer obtained after firing and a silicon semiconductor substrate is enhanced and in that reaction of the aluminum electrode layer and moisture is suppressed. In the present invention, the glass frit including the limited kind of the transition metal oxide is included in the paste, thereby allowing the reaction of the aluminum and the silicon to be controlled so as not to excessively progress. It is considered that this allows blisters and globules of aluminum caused in the aluminum electrode layer obtained after the firing to be suppressed.

In addition, the glass frit including the limited kind of the transition metal oxide is included in the paste, thereby allowing not only the reaction of the aluminum and the silicon to be controlled but also the reaction of the aluminum and the moisture to be suppressed, though the mechanism is not clear.

Furthermore, the glass frit including the limited kind of the transition metal oxide is included in the paste, thereby allowing a mechanical strength of the aluminum electrode layer to be enhanced and adhesiveness of the aluminum electrode layer and the silicon of the substrate to be enhanced.

As the limited kind of the transition metal oxide, at least one kind selected from the group consisting of a titanium oxide, a vanadium oxide, an iron oxide, a molybdenum oxide, a neodymium oxide, and a tungsten oxide can be used.

The glass frit in the present invention includes the above-mentioned at least one kind of the transition metal oxide as an essential ingredient. However, as an oxide for composing glass having predetermined characteristics, at least one kind selected from the group consisting of a boron oxide, a bismuth oxide, a silicon oxide, an aluminum oxide, a tin oxide, a phosphorus oxide, a manganese oxide, a barium oxide, an antimony oxide, a lithium oxide, a sodium oxide, and a potassium oxide can be further included therein and used.

Although a content of the above-mentioned limited kind of the transition metal oxide included in the glass frit in the present invention is not particularly limited, it is preferable that the content of the transition metal oxide is greater than or equal to 10% by mass and less than or equal to 95% by mass in the glass frit. If the content of the transition metal oxide is less than 10% by mass, an effect obtained by adding the transition metal oxide is insufficient, and the characteristics in that the adhesiveness of the aluminum electrode layer and the silicon semiconductor substrate is enhanced and in that the reaction of the aluminum electrode layer and the moisture is suppressed cannot be achieved. It is preferable that the content of the transition metal oxide is greater than or equal to 25% by mass, and it is more preferable that the content of the transition metal oxide is greater than or equal to 30% by mass. Although an upper limit of the content of the transition metal oxide is not particularly limited, a content of the transition metal oxide exceeding 95% by mass is not preferable since vitrification is made difficult. In the glass frit in the present invention, other oxide or compound is further included and used as an accessory ingredient as needed.

A method for manufacturing the glass frit in the present invention is not particularly limited, and by employing the heretofore known method for manufacturing glass, mixing of various kinds of raw materials so as to achieve the predetermined composition of the glass frit, melting, vitrification, pulverization, drying, and classification are conducted, thereby obtaining the predetermined glass frit.

In the paste composition according to the present invention, it is preferable that a content of the glass frit in the paste composition is greater than or equal to 0.03% by mass and less than or equal to 10% by mass. If the content of the glass frit is less than 0.03% by mass, although the both characteristics in that the adhesiveness of the aluminum electrode layer and the silicon semiconductor substrate is enhanced and in that the reaction of the aluminum electrode layer and the moisture is suppressed can be achieved, the content thereof being less than 0.03% by mass is not preferable since causing the blisters and the globules of aluminum in the aluminum electrode layer cannot be sufficiently suppressed, thereby increasing a surface resistance of the aluminum electrode layer and a surface resistance of the p⁺ layer. In a case where the content of the glass frit exceeds 10% by mass, the both characteristics in that the adhesiveness of the aluminum electrode layer and the silicon semiconductor substrate is enhanced and in that the reaction of the aluminum electrode layer and the moisture is suppressed can be achieved and causing the blisters and the globules of aluminum in the aluminum electrode layer can be suppressed. However, since bow of the silicon semiconductor substrate cannot be sufficiently suppressed, the content thereof exceeding 10% by mass is not preferable. It is more preferable that the content of the glass frit is greater than or equal to 0.05% by mass and less than or equal to 8% by mass.

Although an average particle diameter of particles of the glass frit included in the paste composition according to the present invention is not particularly limited, it is preferable that the average particle diameter is less than or equal to 10 µm.

### <Aluminum Powder>

It is preferable that a content of the aluminum powder included in the paste composition according to the present invention is greater than or equal to 60% by mass and less than or equal to 85% by mass. If the content of the aluminum powder is less than 60% by mass, it is likely that a resistance of the aluminum electrode layer obtained after the firing is increased and a reduction in an energy conversion efficiency of the solar cell is incurred. If the content of the aluminum powder exceeds 85% by mass, application properties of the paste in screen printing or the like is reduced.

In the present invention, an aluminum powder having an average particle diameter in a wide range from 1 through 20 µm can be used. In a case where an aluminum powder is mixed in the paste composition, preferably, an aluminum powder having an average diameter ranging from 2 through 15 µm can be used, and further preferably, an aluminum powder having an average diameter ranging from 3 through 10 µm can be used. The average particle diameter thereof being less than 1 µm is not preferable since a specific surface area of the aluminum powder is increased. The average particle diameter thereof exceeding 20 µm is not preferable since an appropriate viscosity cannot be obtained when the paste composition is composed by including the aluminum powder therein. In addition, a shape of each of the particles and a manufacturing method of the aluminum powder included in the paste composition according to the present invention are not particularly limited.

### <Organic Vehicle>

Ingredients of the organic vehicle included in the paste composition according to the present invention are not particularly limited. However, a resin such as an ethyl cellulose resin and an alkyd resin and a solvent such as a glycol ether based solvent and a terpineol based solvent can be used. It is preferable that a content of the organic vehicle in the paste is greater than or equal to 15% by mass and less than or equal to 40% by mass. If the content of the organic vehicle is less than 15% by mass, printing properties of the paste is reduced and a favorable aluminum electrode layer cannot be thereby formed. In addition, if the content of the organic vehicle exceeds 40% by mass, not only a viscosity of the paste is increased, but also a problem in that the organic vehicle being excessively present hinders the firing of the aluminum is caused. Although a ratio of mixing the resin in the organic vehicle is not particularly limited, it is preferable that the ratio is greater than or equal to 5% by mass and less than or equal to 20% by mass.

### <Others>

In the paste composition according to the present invention, a variety of additives, such as a dispersant, a plasticizer, an anti-settling agent, and a thixo-agent, which adjust properties of the aluminum paste can be included and used as needed. Although composition of each of the additives is not particularly limited, it is preferable that a content thereof is less than or equal to 10% by mass.

### EXAMPLES

Hereinafter, examples of the present invention will be described.

First, a paste composition was prepared by adding 65% through 80% by mass of an aluminum powder; 20% through 35% by mass of an organic vehicle obtained by dissolving 10% by mass of ethyl cellulose in 90% by mass of a glycol ether based organic solvent; and a glass frit including a ratio of each limited kind of a transition metal oxide shown in Table 1.

Specifically, the glass frit including each limited kind of the transition metal oxide, whose added amount is shown in Table 1, and the aluminum powder were added to the organic vehicle obtained by dissolving the ethyl cellulose in the glycol ether based organic solvent, and the resultant was mixed by a well-known mixer, thereby preparing each paste composition (examples 1 through 12). In addition, by employing the same method as described above, each paste composition (comparison examples 1 through 5) to which each glass frit including a transition metal oxide other than each of the limited kinds of the transition metal oxides in the present invention or the conventional glass frit including no transition metal oxide was added was prepared.

Here, in view of ensuring of reactivity with the silicon semiconductor substrate, application properties, and evenness of a coating film, as the aluminum powder, a powder composed of particles each having a spherical shape or a near-spherical shape, whose average particle diameter was 3 through 10 µm, was used. The glass frit whose average particle diameter was 1 through 5 µm was used.

Each of the paste compositions prepared as described above was applied and printed onto a p-type silicon semiconductor substrate having a thickness of 180 µm and a size of 155 mm × 155 mm by using a 165-mesh screen printing plate and was dried. An application amount was set in a manner such that an application amount before drying was 1.5 ± 0.1 g/piece.

After the p-type silicon semiconductor substrate having the paste printed thereon was dried, each paste was fired in an air atmosphere in an infrared continuous firing furnace. A temperature in a firing zone of the firing furnace was set to be 780°C through 800°C and a residence time (firing time) of the substrate was set to be 6 through 10 seconds. After the firing, a structure in which an aluminum electrode layer 5 and an Al-Si alloy layer 6 were formed on the p-type silicon semiconductor substrate 1 as shown in Fig. 1 was obtained.

In the aluminum electrode layer 5 formed on the silicon semiconductor substrate, an amount of emergence of blisters and globules of aluminum per measurement surface area 150 × 150 mm² of the aluminum electrode layer 5 was visually counted. A total value thereof is shown in Table 1. A targeted value of the amount of emergence of blisters and globules of aluminum to prevent the occurrence of cracks of the silicon semiconductor substrate in a manufacturing process is set to be 5.

A surface resistance of a back side electrode 8 composed of the aluminum electrode layer 5 and the Al-Si alloy layer 6, which exerts an influence on an ohmic resistance between electrodes, was measured by using a four-probe type surface resistance measuring apparatus.

Thereafter, a mechanical strength and an adhesion property of the aluminum electrode layer 5 formed on the p-type silicon semiconductor substrate 1 were evaluated in a manner such that a cellophane adhesive tape was attached onto a surface of the aluminum electrode layer 5 and peeled off and whether or not the aluminum electrode layer 5 was peeled off and a degree of peeling-off were examined. An evaluation A indicates that the peeling-off of the aluminum electrode layer 5 was hardly observed; an evaluation B indicates that the peeling-off of the aluminum electrode layer 5 was slightly observed; and an evaluation C indicates that the peeling-off of the aluminum electrode layer 5 was considerably observed.

Furthermore, the p-type silicon semiconductor substrate 1 having the back side electrode 8 formed thereon was immersed in a hydrochloric acid aqueous solution, the aluminum electrode layer 5 and the Al-Si alloy layer 6 were thereby dissolved to be removed, and a surface resistance of the p-type silicon semiconductor substrate 1 having a p⁺ layer 7 formed thereon was measured by using the above-mentioned surface resistance measuring apparatus.

It is assumed that there is a correlation between the surface resistance of the aluminum electrode layer 5 and electrode characteristics of the aluminum electrode layer 5, and the smaller surface resistance is more advantageous for the electrode characteristics. In addition, it is assumed that there is a correlation between a surface resistance of the p⁺ layer 7 and a BSF effect, and the smaller the surface resistance is, the higher the BSF effect is. Here, a targeted value of the surface resistance of the aluminum electrode layer 5 is less than or equal to 18 mΩ/sq. and a targeted value of the surface resistance of the p⁺ layer 7 is less than or equal to 16 Ω/sq.

Reactivity of the aluminum electrode layer 5 to moisture was evaluated in a manner such that the p-type silicon semiconductor substrate 1 having the back side electrode 8 formed thereon was immersed in warm water having a temperature of 70°C ± 2°C for three minutes and whether or not gas was generated from a surface of the aluminum electrode layer 5 during the immersion and whether or not the aluminum electrode layer 5 after the immersion was discolored were visually observed. An evaluation A indicates that the generation of the gas from the surface of the aluminum electrode layer 5 during the immersion was hardly observed; an evaluation B indicates that the generation of the gas from the surface of the aluminum electrode layer 5 during the immersion was slightly observed; and an evaluation C indicates that the generation of the gas from the surface of the aluminum electrode layer 5 during the immersion was considerably observed. An evaluation A indicates that the discoloring of the aluminum electrode layer 5 after the immersion was hardly observed; an evaluation B indicates that the discoloring of the aluminum electrode layer 5 after the immersion was slightly observed; and an evaluation C indicates that the discoloring of the aluminum electrode layer 5 after the immersion was considerably observed.

The amount of emergence of blisters and globules of aluminum, the surface resistance of the back side electrode 8, the surface resistance of the p⁺ layer 7, which were measured as described above, and the results of the exfoliation test and the water immersion tests are shown in Table 1.

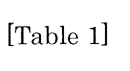

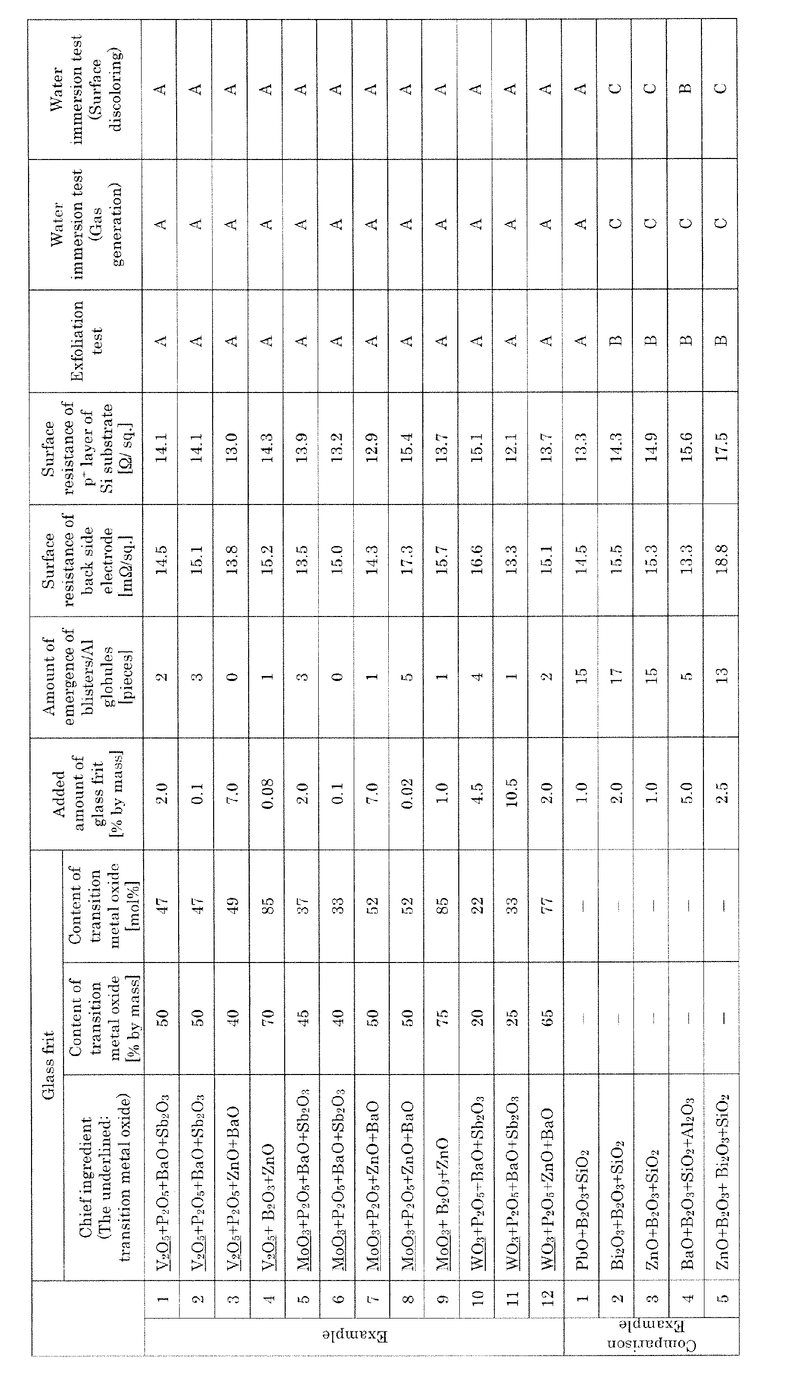

It is seen from the result shown in Table 1 that by using each of the paste compositions (examples 1 through 12) according to the present invention, which used the glass frit including each of the limited kinds of the transition metal oxides, the adhesiveness of the aluminum electrode layer can be improved without reducing the electrode function of the aluminum electrode layer and the BSF effect; the reaction of the aluminum electrode layer and the moisture can be suppressed; and further, the emergence of the blisters and the globules of aluminum can be suppressed, as compared with the paste compositions (comparison examples 1 through 5) to which the conventional glass frit including none of the limited kinds of the transition metal oxides in the present invention was added.

The described embodiment and examples are to be considered in all respects only as illustrative and not restrictive. It is intended that the scope of the invention is, therefore, indicated by the appended claims rather than the foregoing description of the embodiment and examples and that all modifications and variations coming within the meaning and equivalency range of the appended claims are embraced within their scope.

### INDUSTRIAL APPLICABILITY

### REFERENCE SIGNS LIST

1: p-type silicon semiconductor substrate, 2: n-type impurity layer, 3: antireflection film, 4: grid electrode, 5: aluminum electrode layer, 6: Al-Si alloy layer, 7: p⁺ layer, 8: back side electrode.

## Claims

1. A paste composition being a paste used for forming an electrode (8) on a silicon semiconductor substrate (1), comprising: an aluminum powder, an organic vehicle, and glass frit, the glass frit including at least one kind of a transition metal oxide selected from the group consisting of a titanium oxide, a vanadium oxide, an iron oxide, a molybdenum oxide, a neodymium oxide, and a tungsten oxide.

2. The paste composition according to claim 1, wherein the glass frit includes no lead.

3. The paste composition according to claim 1, wherein the glass frit includes 0.1% by mass or less of lead.

4. The paste composition according to claim 1, wherein the glass frit further includes at least one kind selected from the group consisting of a boron oxide, a bismuth oxide, a silicon oxide, an aluminum oxide, a tin oxide, a phosphorus oxide, a manganese oxide, a barium oxide, an antimony oxide, a lithium oxide, a sodium oxide, and a potassium oxide.

5. The paste composition according to claim 1, wherein the glass frit includes 10% by mass or more and 95% by mass or less of the transition metal oxide.

6. The paste composition according to claim 1, comprising 0.03% by mass or more and 10% by mass or less of the glass frit.

7. A solar cell element comprising an electrode (8) formed by applying the paste composition according to claim 1 onto a silicon semiconductor substrate (1) and thereafter, firing a resultant.
